# EUROPÄISCHE PATENTSCHRIFT

(11) **EP 1 504 531 B1**
(45) Veröffentlichungstag und Bekanntmachung des Hinweises auf die Patenterteilung: **08.11.2006**
(21) Anmeldenummer: 02807383.1
(22) Anmeldetag: 13.05.2002
(51) Int. Cl.: H03M 1/10

(54) **DIGITAL-ANALOG-UMSETZER MIT INTEGRIERTER PRÜFSCHALTUNG**
DIGITAL-TO-ANALOG CONVERTER COMPRISING AN INTEGRATED TEST CIRCUIT
CONVERTISSEUR NUMERIQUE-ANALOGIQUE COMPORTANT UN CIRCUIT DE TEST INTEGRE

(43) Veröffentlichungstag der Anmeldung: 09.02.2005
(73) Patentinhaber: austriamicrosystems AG, 8141 Unterpremstätten (AT)
(72) Erfinder: THEILER, Helmut, A-8501 Lieboch (AT)
(74) Vertreter: Haffner, Thomas M.
(86) Internationale Anmeldenummer: PCT/AT2002/000144
(87) Internationale Veröffentlichungsnummer: WO 2003/096539

(56) Entgegenhaltungen:
- SU-A- 1 494 216
- US-A- 4 641 246

## Beschreibung

Die Erfindung betrifft einen Digital-Analog-Umsetzer mit integrierter Prüfschaltung, welcher einen digitalen Eingang und einen analogen Ausgang aufweist.

Digital-Analog-Umsetzer (DAU) dienen der Umsetzung eines digitalen Eingangscodes in die entsprechende analoge Ausgangsspannung. Das Einsatzgebiet liegt bei digitalen Systemen, wo eine schnelle hochgenaue und hochauflösende Umwandlung erforderlich ist.

In der überwiegenden Mehrheit der herkömmlichen DAU wird der digitale Eingangscode einer Analog-Schalter-Matrix zugeführt, die über ein Widerstandsnetzwerk binär gestufte Teilströme erzeugt. Alle Teilströme werden in einer Summiereinheit addiert und gegebenenfalls noch verstärkt, sodaß am Ausgang eine dem angelegten Eingangscode proportionale Spannung abgegriffen werden kann. Gründsätzlich wird daher zwischen Digital-Analog-Umsetzern mit Strom- oder Spannungsausgang unterschieden.

Die DAU erfordern eine hohe Anzahl an Bauteilen. Die Widerstandswerte müssen genau aufeinander abgeglichen werden, wobei das Drift-Verhalten möglichst identisch sein soll. Die Streukapazität so wie Schaltverzögerungen der Analog-Schalter verursachen hohe transiente Spannungsspitzen. Da DAU mit einem niederohmigen Stromausgang und gegebenenfalls dem vom Eingangscode abhängigen Ausgangswiderstand kaum brauchbar sind, setzt man Ausgangsverstärker ein. Die neuen Fehlerquellen, wie z.B. off-setSpannung, Neigung zu Überschwingen, hohe Impulsverzögerungszeit, müssen dabei in Kauf genommen werden.

Grundsätzlich unterscheidet man bei Digital-Analog-Umsetzern statische und dynamische Kenngrößen. Eine wichtige dynamische Kenngröße stellt die Einschwingzeit dar, die angibt, wie lange es nach der Umschaltung der Zahl Z von V auf Z max. dauert, bis das Ausgangssignal mit einer Genauigkeit von z.B. 1/2 LSB (least significant bit) den stationären Wert erreicht hat. Dann erst steht das Analogsignal mit der durch die Auflösung des Digital-Analog-Umsetzers gegebenen Genauigkeit zur Verfügung. Der Bezug auf 1/2 LSB bringt es natürlich mit sich, daß DAU mit derselben Zeitkonstante bei größerer Auflösung langsamer auf 1/2 LSB einschwingen.

In vielen Fällen werden Digital-Analog-Umsetzer benötigt, welche eine geringe Einschwingzeit aufweisen. In der Vergangenheit wurde bei vielen DA-Umseztern primär ein Strom gebildet, der bei Bedarf unter Verwendung eines "off-chip" Widerstands in eine Spannung umgewandelt werden konnte. Die Einschwingzeit solcher DA-Umsetzer ist durch den off-chip-Widerstand und die kapazitive Last am entsprechenden Anschluß bestimmt.

Heutzutage gelangen vermehrt Spannungs-DAU zum Einsatz, bei welchen der Strom mit einem nachfolgenden Operationsverstärker in eine Spannung umgewandelt werden kann. Zur Einschwingzeit des DA-Umsetzers selbst addiert sich in diesen Fällen noch die Einschwingzeit des Operationsverstärkers, die aufgrund der Rückkoppelungsschleife meist deutlich größer ist als die des DA-Umsetzers. Mit derartigen Umsetzern kann zwar der Leistungsverlust wesentlich herabgesetzt werden, jedoch sollte jedenfalls die Einschwingzeit während des Produktionsprozesses überprüft werden. Dies stellt jedoch dann ein Problem dar, wenn Umsetzer mit Einschwingzeiten in der Größenordnung von einigen 10 Nanosekunden realisiert werden sollen. Aus dem Dokument SU-A-1494216 sind ein Gerät und Verfahren zur Messung der Einschwingzeit des Ausgangssignals eines Digital-Analog-Umsetzers bekannt, in welches eine Prüfschaltung dieses Ausgangssignal während eines von zwei vorgegebenen Referenzspannungen bestimmten Zeitintervalls integriert und darauf eine der Differenz der Referenzspannungen proportionalen konstanten Spannung in entgegengesetzter Richtung integriert bis das Ausgangssignal des Integrators kleiner als der Einschwingtoleranz ist. Aus einer Messung letzterer Integrationszeit wird die Einschwingzeit also nach einer Art Zweirampenverfahren ermittelt. Das Dokument US-A-4641246 beschreibt ebenfalls ein Gerät und Verfahren zur Messung der Einschwingzeit des Ausgangssignals eines Digital-Analog-Umsetzers, in welches Gerät die Prüfschaltung zur allgemeinen Anwendung bestimmt und also nicht mit dem Umsetzer integriert ist, und in welches Verfahren die Einschwingzeit von einem Digitalrechner rechnerisch ermittelt wird aus einer digitalisierten Darstellung der ganzen Wellenform, welche mit verschiebender Phase abgetastet wird. Beide eignen sich daher aber nicht zur Messung von Einschwingzeiten in der Ordnung von einigen Nanosekunden. Ziel der vorliegenden Erfindung ist es somit, einen Digital-Analog-Umsetzer zu schaffen, welcher eine integrierte Prüfschaltung aufweist, mit welcher die Einschwingzeit des DAU auch dann noch sicher gemessen werden kann, wenn höchstzulässige Einschwingzeiten von einigen Nanosekunden eingehalten werden sollen. Die integrierte Prüfschaltung soll auch in der Lage sein, die Einschwingzeiten dann zu messen, wenn eine größere Anzahl von DAU (16 oder mehr) in einer Einheit realisiert werden.

Zur Lösung dieser Aufgabe besteht die Erfindung im wesentlichen darin, daß ein mit dem analogen Ausgang verbindbarer Komparator vorgesehen ist, welcher einen Anschluß für eine Referenzspannungsquelle, einen digitalen Prüfanschluß und eine Logikschaltung aufweist, wobei die Logikschaltung mit dem Prüfanschluß zur Ausgabe des digitalen Wertes 0 oder 1 in Abhängigkeit von der Differenz zwischen der Spannung am analogen Ausgang und der Referenzspannung verbunden ist. Dadurch, daß der analoge Ausgang des Digital-Analog-Umsetzers nun mit einem Komparator verbindbar ist, wird die Möglichkeit geschaffen, den vom DAU gelieferten analogen Spannungswert mit einem entsprechenden Referenzwert zu vergleichen. Zu diesem Zweck weist der Komparator erfindungsgemäß einen Anschluß für eine Referenzspannungsquelle auf, wobei weiters ein digitaler Prüfanschluß und eine Logikschaltung vorgesehen sind, wobei die Logikschaltung mit dem Prüfanschluß zur Ausgabe des digitalen Wertes 0 oder 1 in Abhängigkeit von der Differenz zwischen der Spannung am analogen Ausgang und der Referenzspannung verbunden ist. Die Logikschaltung des Komparators wirkt hierbei mit dem Prüfanschlußwert so zusammen, daß der Schaltzustand des Prüfanschlusses dann geändert wird, wenn die vom Komparator ermittelte Differenz zwischen der Spannung am analogen Ausgang und der Referenzspannung kleiner der Einschwingtoleranz (z.B. 1/2 LSB) wird. Da die Referenzspannungsquelle dem analogen Zielwert des am Eingang des DAU anliegenden digitalen Wortes entspricht, kann auf einfache Art und Weise durch ein externes, ausschließlich digital arbeitendes Prüfgerät die Einschwingzeit des DAUs ermittelt werden. Zu diesem Zweck wird vom externen Prüfgerät die Zeit zwischen dem Anlegen des digitalen Wortes an den Eingang des Digital-Analog-Umsetzers und der Zeit, zu der der Fensterkomparator ein stabiles Gleichheitsergebnis am digitalen Prüfanschluß anzeigt, gemessen. Das Prüfgerät arbeitet somit ausschließlich auf Basis eines digitalen pattern-Tests (ja/nein), was in sehr einfacher Weise durch übliche digitale Testsysteme verwirklicht werden kann. Es ist somit für die Erfindung wesentlich, daß der Komparator einen digitalen Prüfanschluß aufweist, da durch die digitale Arbeitsweise des Prüfgerätes auch Einschwingzeiten im Bereich von einigen Nanosekunden erfaßt werden können.

In bevorzugter Weise ist der Anschluß für die Referenzspannungsquelle über einen Schalter mit dem analogen Ausgang verbunden. Auf diese Art und Weise wird der Anschluß für die Referenzspannungsquelle unmittelbar mit dem dem digitalen Prüfwort entsprechenden analogen Wert verbunden, sodaß beispielsweise für den Fall, daß, wie es einer bevorzugten Weiterbildung der Erfindung entspricht, die Referenzspannungsquelle von einem Kondensator gebildet ist, unmittelbar die gewünschte Referenzspannung zur Verfügung steht und beispielsweise in einem Kondensator gespeichert werden kann. Wird der Schalter geöffnet, steht die entsprechende Referenzspannung unmittelbar dem Komparator zur Verfügung. Wie bereits erwähnt, kann der digitale Analog-Umsetzer als Strom-DA-Umsetzer mit nachgeschaltetem Operationsverstärker ausgebildet sein. Eine besonders vorteilhafte Ausbildung ergibt sich dadurch, daß der Digital-Analog-Umsetzer, der Komparator und gegebenenfalls der Kondensator als integrierter Schaltkreis ausgebildet sind. Die integrierte Prüfschaltung kann somit als "on-chip"-Ausführung ausgebildet werden und in einen integrierten Schaltkreis integriert werden. Dadurch wird eine besonders kompakte Ausführung gewährleistet, wobei die Einschwingzeit des Digital-Analog-Umsetzers in einfacher Weise von außen über den digitalen Prüfanschluß erfolgt.

Wie bereits erwähnt, kann die Referenzspannungsquelle, also beispielsweise der Kondensator, "on-chip" angeordnet sein, sodaß die Referenzspannung unmittelbar im integrierten Schaltkreis zur Verfügung steht und nicht von außen zugeführt werden muß. Der Vorteil, die DAU-Ausgangsspannung an einem Kondensator zu speichern und so die Referenzspannung zu generieren, besteht darin, daß die Referenzspannung praktisch keinen Fehler bezüglich der eingeschwungenen DAU-Ausgangsspannung hat.

Wenn eine größere Anzahl von DAUs in einer Einheit integriert sind, kann die Meßeinheit (Fensterkomparator plus VREF-Speicherkapazität) sequenziell zum Testen aller DAUs verwendet werden.

Die Erfindung betrifft auch ein Verfahren zur Bestimmung der Einschwingzeit von Digital-Analog-Umsetzern, welches im wesentlichen durch folgende Schritte gekennzeichnet ist:
- Anlegen eines einem gespeicherten analogen Zielwert entsprechenden digitalen Wortes an den Eingang des Digital-Analog-Umsetzers
- Vergleichen des analogen Signals am Ausgang des Digital-Analog-Umsetzers mit dem gespeicherten analogen Zielwert
- Generierung eines digital auswertbaren Signals sobald die Differenz zwischen dem analogen Signal am Ausgang des Digital-Analog-Umsetzers und dem gespeicherten analogen Zielwert kleiner der Einschwingzeittoleranz (z.B. 1 LSB) ist
- Messen der Zeit zwischen dem Anlegen des digitalen Wortes an den Eingang des Digital-Analog-Umsetzers und der Generierung des digital auswertbaren Signals.

Es wird also zunächst ein digitales Wort an den Eingang des Digital-Analog-Umsetzers angelegt, wobei dieses digitale Wort einem analogen Zielwert entspricht. Das Speichern des analogen Zielwertes kann, wie bereits erwähnt, beispielsweise durch das Aufladen eines Kondensators mit der analogen Spannung am Dau-Ausgang erfolgen. Nun kann die Einschwingzeit von einem Dau-Spannungswert zu dem zuvor gespeicherten Zielwert erfolgen, wobei ein digitales Signal signaliert, wann die Differenz zwischen dem analogen Signal und dem gespeicherten analogen Zielwert kleiner der Einschwingtoleranz ist. Das digital auswertbare Signal besteht im einfachsten Fall aus dem Zustand 0 oder 1 eines digitalen Prüfanschlusses. Die eigentliche Messung der Einschwingzeit erfolgt erfindungsgemäß ausschließlich digital, wobei die Einschwingzeit der Zeit zwischen dem Anlegen des digitalen Wortes an den Eingang des Digital-Analog-Umsetzers und der Generierung des digital auswertbaren Signals entspricht.

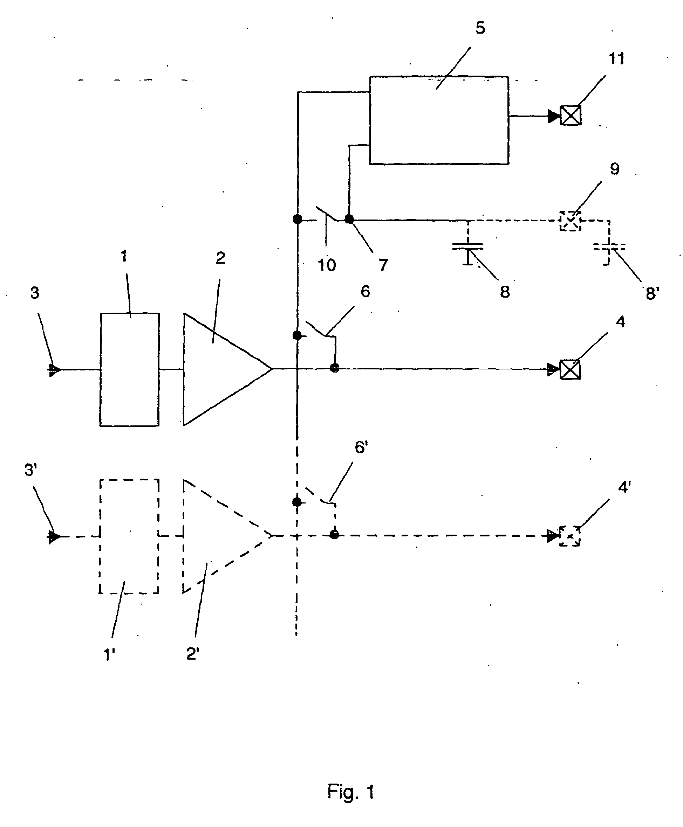

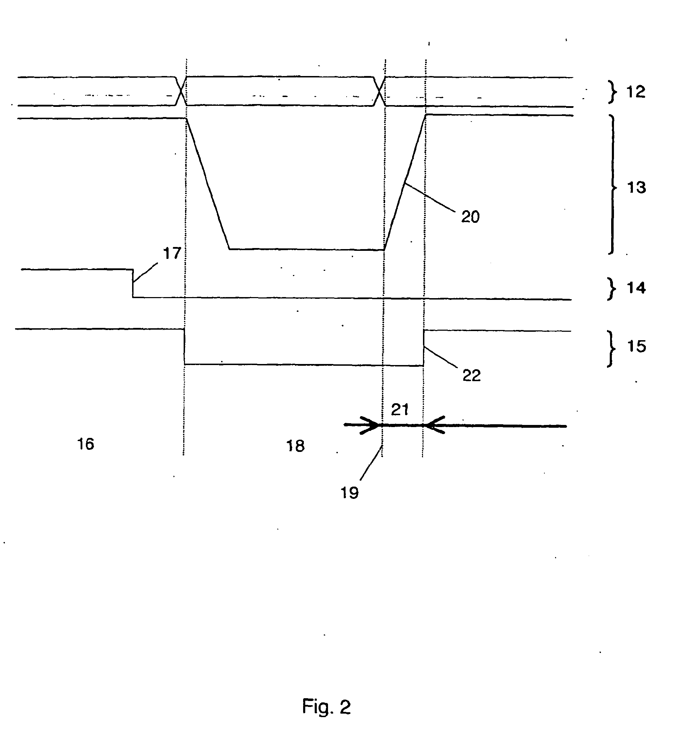

Die Erfindung wird nachfolgend anhand eines in der Zeichnung schematisch dargestellten Ausführungsbeispieles des Digital-Analog-Umsetzers erläutert. In dieser zeigt Figur 1 ein Blockschaltbild des Digital-Analog-Umsetzers mit integrierter Prüfschaltung und Figur 2 die Zustände der einzelnen Anschlüsse.

In Figur 1 ist ein Digital-Analog-Umsetzer 1 mit nachgeschaltetem Operationsverstärker 2 dargestellt. Der digitale Eingang des Digital-Analog-Umsetzers 1 ist mit 3 bezeichnet. Der analoge Ausgang des Digital-Analog-Umsetzers ist mit 4 bezeichnet, wobei ein Komparator 5 über einen Schalter 6 mit dem Ausgang 4 verbunden ist. Der Komparator 5 weist einen Anschluß 7 für einen Kondensator 8 auf, welcher "on-chip" angeordnet ist. Der Anschluß 7 kann jedoch, wie strichliert dargestellt, über einen Anschluß 9 mit einem externen Kondensator 8' verbunden sein. Weiters ist ein Schalter 10 vorgesehen, über welchen der Kondensator 8 bzw. 8' mit dem analogen Ausgang 4 des Digital-Analog-Umsetzers verbunden werden kann. Der digitale Prüfanschluß des Komparators 5 ist mit 11 bezeichnet. Wie strichliert angedeutet, können weitere Umsetzerstufen 1', 2' vorgesehen sein, welche über einen Schalter 6' mit dem Komparator 5 und der gesamten Prüfschaltung verbindbar sind.

Zur Messung der Einschwingzeit des Digital-Analog-Umsetzers kann folgendermaßen vorgegangen werden: Zunächst wird an den zu testenden Digital-Analog-Wandler ein digitales Wort angelegt, welches einer analogen Zielspannung entspricht. Um die vom DAU ausgegebene Zielspannung als Referenzspannung zu speichern, wird der Schalter 6 sowie der Schalter 10 geschlossen und damit diese Spannung im Kondensator 8 gespeichert, worauf der Schalter 10 geöffnet wird. Die einzelnen Schaltzustände sind in Figur 2 näher dargestellt, wobei im Bereich 12 der am digitalen Anschluß 3 anliegende digitale Code, im Bereich 13 die Spannung am analogen Ausgang 4, im Bereich 14 der Zustand des Schalters 10 und im Bereich 15 der Zustand des digitalen Prüfanschlusses 11 ersichtlich ist. Im ersten zeitlichen Abschnitt 16 des Prüfverfahrens wird, wie bereits erwähnt, der Kondensator 8 mit der Referenzspannung geladen, worauf der Schalter 10 geöffnet wird, wie durch die Stufe 17 dargestellt. Dadurch bleibt die Referenzspannung im Kondensator 8 gespeichert. Im darauf folgenden-Zeitbereich 18 liegt am digitalen Anschluß 3 ein anderer digitaler Code an, sodaß sich auch die Spannung am Anschluß 4 ändert. Der Prüfanschluß 11 nimmt dadurch einen anderen Schaltzustand an, da die Differenz zwischen der im Kondensator 8 gespeicherten Spannung und der Spannung am analogen Ausgang 4 größer als die Einschwingtoleranz ist. Zum Zeitpunkt 19 beginnt nun der eigentliche Meßvorgang. An den digitalen Anschluß 3 des Digital-Analog-Umsetzers 1 wird wieder der ursprüngliche digitale Zielcode angelegt, worauf sich die Ausgangsspannung des DAU 1 nach einer gewissen zeit, welche durch die Flanke 20 gekennzeichnet ist, auf den analogen Zielwert einschwingt. Die entsprechende Einschwingzeit ist mit 21 gekennzeichnet. Während der Einschwingzeit vergleicht der Komparator 5 die Differenz zwischen der in Kondensator 8 gespeicherten Referenzspannung und der Spannung am analogen Ausgang 4, und sobald diese Differenz kleiner als die Einschwingtoleranz ist, wird der Schaltzustand des digitalen Prüfanschlusses 11, wie durch die Stufe 22 dargestellt, geändert. Dadurch erkennt ein externes Meßgerät, daß die Spannung am Ausgang 4 die Zielspannung erreicht hat und der' Einschwingvorgang abgeschlossen ist.

Insgesamt ist der Digital-Analog-Umsetzer somit mit einer Prüfschaltung ausgestattet, welche es auf einfache Art und Weise zuläßt, die Einschwingzeit vollständig digital zu messen und somit auch Einschwingzeiten zuverlässig zu messen, welche sich im Bereich von einigen Nanosekunden bewegen. Die gesamte Prüfschaltung befindet sich "on-chip", und es kann dadurch in zuverlässiger Weise die Messung bereits während des Produktionsprozesses vorgenommen werden, um die DA-Umsetzer, welche nicht den geforderten werten für die Einschwingzeit entsprechen, sofort aus der Produktionsstraße zu entfernen.

## Patentansprüche

1. Digital-Analog-Umsetzer mit integrierter Prüfschaltung, welcher einen digitalen Eingang und einen analogen Ausgang aufweist, **dadurch gekennzeichnet, daß** ein mit dem analogen Ausgang (4) verbindbarerer Komparator (5) vorgesehen ist, welcher einen Anschluß (7) für eine Referenzspannungsquelle, einen digitalen Prüfanschluß (11) und eine Logikschaltung aufweist, wobei die Logikschaltung mit dem Prüfanschluß (11) zur Ausgabe des digitalen Wertes 0 oder 1 in Abhängigkeit von der Differenz zwischen der Spannung am analogen Ausgang (4) und der Referenzspannung verbunden ist.

2. Digital-Analog-Umsetzer nach Anspruch 1, **dadurch gekennzeichnet, daß** der Anschluß (7) für die Referenzspannungsquelle über einen Schalter (10) mit dem analogen Ausgang (4) verbunden ist.

3. Digital-Analog-Umsetzer nach Anspruch 1 oder 2, **dadurch gekennzeichnet, daß** die Referenzspannungsquelle von einem Kondensator (8) gebildet ist.

4. Digital-Analog-Umsetzer nach Anspruch 1, 2 oder 3, **dadurch gekennzeichnet, daß** der Digital-Analog-Umsetzer (1) als Strom-DA-Umsetzer mit nachgeschaltetem Operationsverstärker (2) ausgebildet ist.

5. Digital-Analog-Umsetzer nach einem der Ansprüche 2 bis 4, **dadurch gekennzeichnet, daß** der Digital-Analog-Umsetzer (1), der Komparator (5) und gegebenenfalls der Kondensator (8) als integrierter Schaltkreis ausgebildet sind.

6. Verfahren zur Bestimmung der Einschwingzeit von Digital-Analog-Umsetzern **gekennzeichnet durch** die Schritte
- Anlegen eines einem gespeicherten analogen zielwert entsprechenden digitalen Wortes an den Eingang des Digital-Analog-Umsetzers
- Vergleichen des analogen Signals am Ausgang des Digital-Analog-Umsetzers mit dem gespeicherten analogen Zielwert
- Generierung eines digital auswertbaren Signals sobald die Differenz zwischen dem analogen Signal am Ausgang des Digital-Analog-Umsetzers und dem gespeicherten analogen Zielwert kleiner der Einschwingtoleranz ist
- Messen der Zeit zwischen dem Anlegen des digitalen Wortes an den Eingang des Digital-Analog-Umsetzers und der Generierung des digital auswertbaren Signals.

## Claims

1. A digital-to-analog converter including an integrated test circuit, a digital input and an analog output, **characterized in that** a comparator (5) capable of being connected with the analog output (4) and comprising a connection (7) for a reference voltage source, a digital test connection (11) and a logic element is provided, said logic element being connected with the test connection (11) for emitting the digital value 0 or 1 as a function of the difference between the voltage at the analog output (4) and the reference voltage.

2. A digital-to-analog converter according to claim 1, **characterized in that** the connection (7) for the reference voltage source is connected with the analog output (4) via a switch (10).

3. A digital-to-analog converter according to claim 1 or 2, **characterized in that** the reference voltage source is comprised of a capacitor (8).

4. A digital-to-analog converter according to claim 1, 2 or 3, **characterized in that** the digital-to-analog converter (1) is designed as a power DA converter comprising a consecutively arranged operation amplifier (2).

5. A digital-to-analog converter according to any one of claims 2 to 4, **characterized in that** the digital-to-analog converter (1), the comparator (5) and optionally the capacitor (8) are designed as an integrated circuit.

6. A method for determining the transient period of a digital-to-analog converter, **characterized by** the steps of:
- applying to the input of the digital-to-analog converter a digital word corresponding to a stored analog target value,
- comparing the analog signal at the output of the digital-to-analog converter with the stored analog target value,
- generating a digitally evaluatable signal as soon as the difference between the analog signal at the output of the digital-to-analog converter and the stored analog target value has become smaller than the transient tolerance,
- measuring the time between the application of the digital word to the input of the digital-to-analog converter and the generation of the digitally evaluable signal.

## Revendications

1. Convertisseur numérique-analogique avec circuit de contrôle intégré, qui comporte une entrée numérique et une sortie analogique, **caractérisé en ce qu'**il est prévu un comparateur (5), qui peut être relié à la sortie analogique (4) et qui comporte un branchement (7) pour une source de tension de référence, un branchement de contrôle numérique (11) et un circuit logique, le circuit logique étant relié au branchement de contrôle (11) pour la sortie de la valeur numérique 0 ou 1 en fonction de la différence entre la tension à la sortie analogique (4) et la tension de référence.

2. Convertisseur numérique-analogique selon la revendication 1, **caractérisé en ce que** le branchement (7) pour la source de tension de référence est relié à la sortie analogique (4) par l'intermédiaire d'un interrupteur (10).

3. Convertisseur numérique-analogique selon la revendication 1 ou 2, **caractérisé en ce que** la source de tension de référence est formée par un condensateur (8).

4. Convertisseur numérique-analogique selon la revendication 1, 2 ou 3, **caractérisé en ce que** le convertisseur numérique-analogique (1) est réalisé sous la forme d'un convertisseur numérique-analogique de courant avec amplificateur opérationnel (2) couplé en aval.

5. Convertisseur numérique-analogique selon l'une des revendications 2 à 4, **caractérisé en ce que** le convertisseur numérique-analogique (1), le comparateur (5) et le cas échéant le condensateur (8) sont réalisés sous la forme d'un circuit intégré.

6. Procédé pour déterminer la durée transitoire de convertisseurs numériques-analogiques par les étapes suivantes :
- application d'un mot numérique, correspondant à une valeur cible analogique mémorisée, à l'entrée du convertisseur numérique-analogique
- comparaison du signal analogique à la sortie du convertisseur numérique-analogique à la valeur cible analogique mémorisée
- génération d'un signal pouvant être exploité de manière numérique dès que la différence entre le signal analogique à la sortie du convertisseur numérique-analogique et la valeur cible analogique mémorisée est inférieure à la tolérance transitoire
- mesure du temps s'écoulant entre l'application du mot numérique à l'entrée du convertisseur numérique-analogique et la génération du signal pouvant être exploité de manière numérique.
